(19) Europäisches Patentamt
European Patent Office
Office européen des brevets

(11) Publication number: **0 083 078**
**B1**

(12) # EUROPEAN PATENT SPECIFICATION

(45) Date of publication of patent specification: **11.11.87**

(51) Int. Cl.$^4$: **G 03 F 7/10**

(21) Application number: **82111931.0**

(22) Date of filing: **23.12.82**

(54) **Photosensitive resin composition and method for forming fine patterns with said composition.**

(30) Priority: **25.12.81 JP 209424/81**
**25.12.81 JP 209425/81**

(43) Date of publication of application:
**06.07.83 Bulletin 83/27**

(45) Publication of the grant of the patent:
**11.11.87 Bulletin 87/46**

(84) Designated Contracting States:
**DE FR GB NL**

(56) References cited:
**EP-A-0 030 107**
**EP-A-0 040 535**
**DE-A-2 948 324**
**FR-A-2 496 111**
**US-A-3 869 292**

**PATENTS ABSTRACTS OF JAPAN, vol. 6, no. 152 (P-134)1030r, 12th August 1982**

(73) Proprietor: **Hitachi, Ltd.**
**5-1, Marunouchi 1-chome**
***Chiyoda-ku Tokyo 100 (JP)***

(73) Proprietor: **Hitachi Chemical Co., Ltd.**
**1-1, Nishi-shinjuku 2-chome Shinjuku-ku**
**Tokyo 160 (JP)**

(72) Inventor: **Kataoka, Fumio**
***Hitachikeimeiryo 850, Maiokacho***
**Totsuka-ku Yokohama (JP)**
Inventor: **Shoji, Fusaji**
**Higashitotsukahaitsu 201, Akibacho**
**Totsuka-ku Yokohama (JP)**
Inventor: **Yokono, Hitoshi**
**8-5, Chuocho**
**Katsuta-shi (JP)**
Inventor: **Makino, Daisuke**
**2849-24, Senbacho**
***Mito-shi (JP)***
Inventor: **Koibuchi, Shigeru**
**8-2, Saiwaicho-1-chome**
**Hitachi-shi (JP)**
Inventor: **Isobe, Asao**
**3-B-204, Nishinarusawacho-3-chome**
**Hitachi-shi (JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 083 078 B1

Courier Press, Leamington Spa, England.

(74) Representative: **Patentanwälte Beetz sen. - Beetz jun. Timpe - Siegfried - Schmitt-Fumian**
**Steinsdorfstrasse 10**
**D-8000 München 22 (DE)**

**Description**

This invention relates to photosensitive resin compositions which may be used for forming fine patterns in the production of microelectronic devices such as semiconductor devices, magnetic bubble devices and optoelectronic devices.

The integration density of integrated semiconductor circuits becomes higher from year to year. Therefore, fine patterns must be formed using high resolution resists in the production of such devices.

Fine patterns are produced by (a) X-ray lithography, (b) electron beam lithography or (c) photo lithography.

However, practical X-ray sources have not been developed for X-ray lithography, and the electron beam lithography requires a relatively long time for drawing the patterns on resists coated on a substrate.

In the photo lithography negative type photoresists and positive type photoresists are used. The negative type photoresists include those which comprise a hydroxystyrene polymer and an aromatic monoazide compound. However, in the case of said photoresists the azide compound used is a solid of high crystalliability which is precipitated from the solution from the coating film when the resists are made into a coating film. Furthermore, the crystals remain as fine particles in unexpected portions which are to be dissolved upon development with an alkaline aqueous solution, and the remaining crystals cause closing up or disruption of patterns.

Other representative negative type photoresists are compositions comprising combinations of cyclized rubbers and aromatic azide compounds. As the aromatic azide compounds, there have been used azidobenzal ketones such as 2,6-bis(4'-azidobenzal)-4-methylcyclohexanone and 2,6-bis(4'-azidobenzal)-cyclohexanone.

The maximum absorption wavelength region of these negative type photoresists is 360 nm corresponding to the aromatic azide compounds used, and since in this region there occur conspicuous interference and diffraction of light, the resolution of this type of photoresists is limited to 1,5 µm. If materials sensitive in a shorter wavelength region are found, the resolution of photoresists is increased. Furthermore, in the case of said negative type photoresists comprising cyclized rubbers and aromatic azide compounds, the developing solution which dissolves uncured portions swells the cured resist at the time of development after curing with UV rays and thus causes expansion or winding of the resist. It is considered that the swelling of the resist per se in addition to the interference and diffraction of light is an important factor for reduction of resolution.

On the other hand, representatives of positive type photoresists are those which comprise combinations of novolak resins and quinonediazide compounds and o-naphthoquinonediazide and some modified ones of these are used as photosensitive materials.

Positive type photoresists are generally superior in resolution and this is considered because the base resin used is an organic substance such as a novolak resin while the developing solution is an alkaline aqueous solution and therefore the resin portion does not swell at the time of development and only the portion exposed to UV rays is dissolved. However, the conventional positive type photoresists have the defects that the maximum absorption wavelength region thereof is 340—450 nm like that of negative type photoresists for obtaining high sensitivity and so they are liable to show reduction in resolution due to interference or diffraction of light.

EP—A—0 030 107 refers to negative type photoresists comprising a novolak resin and an azido compound containing at least one azido group, such as diazido ketones and azido pyrene.

US—A—3 869 292 discloses photosensitive compositions on the basis of polyvinylphenol resins, particularly polymers and copolymers of o-vinylphenol, which may comprise an aromatic azide and a novolak resin.

From EP—A—0 040 535 photosensitive resin compositions are known which comprise at least one polymer selected from novolak resins and polyhydroxystyrene (polyvinylphenol) and an azide compound having two non-conjugated benzene rings in their moleculare structure. It is mentioned in this paper that some azide compounds having only one benzene ring in their structure may fulfil the requirement of maximum absorption in the far-UV region and no high absorption beyond 320 nm, however, they have the disadvantage of volatilization in the prebaking step which is carried out before exposure.

It is the object of this invention to provide photosensitive resin compositions for forming fine photoresist patterns having high resolution, namely, having a maximum absorption wavelength of 330 nm or less and particularly of 290 nm or less and having high sensitivity, and which may have the highest resolution and a maximum absorption wavelength region of 290—200 nm at high sensitivity. Besides, no precipitation of azide compounds from the resist solution should occur, and no residual azide fine particles should remain upon development to remove unexposed portions. The above object is achieved according to claim 1. The photosensitive resin compositions according to the invention comprise (a) at least one polymer compound selected from novolak resins and polyhydroxystyrene resins and (b) an azide compound; they are characterized in that the azide compound is represented by the general formula 1

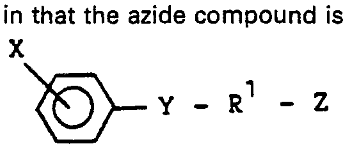

(1),

wherein

X is $-N_3$ or $-SO_2N_3$,

Y is $-COO-$, $-CONH-$, $-NH-$, $-O-$, $-OCO-$, $-NHCO-$, $-CO-$, $-CH=CHCOO-$,

$-CH=CHCONH-$, $-CH=C(CN)COO-$, $-CH=C(CN)CONH-$, $-CH=CHCO-$ or $-COCH=CH-$,

$R^1$ is a lower alkylene, a hydroxyalkylene or an aminoalkylene and

Z is $-R^2$, $-OR^3$ $-N(R^4)(R_5)$,

$-OCOR^6$, $-COOR^7$, $-NHCOR^8$ or $-CONR^4R^5$, wherein $R^2$ and $R^6$ to $R^8$ are lower alkyl, $R^4$ and $R^5$ are lower alkyl or hydrogen, $R^3$ is hydrogen, lower alkyl or $-(CH_2CH_2O)_n-R^9$ wherein n is an integer of 3 or less and $R^9$ is hydrogen or a lower alkyl.

Examples for Z are $-OH$, $-NH_2$, $-N(CH_3)_2$, $-N(C_2H_5)_2$, $-N(C_3H_7)_2$. The negative type photoresists comprising a photosensitive resin composition according to the invention and an organic solvent are coated onto a substrate; after drying the coating, the resultant film is patternwise exposed and then developed with an alkaline aqueous solution to dissolve and remove the unexposed portions.

The conception of this invention will be explained hereinbelow. The use of the high molecular compound (a) avoids an undesired expansion of unexposed portions upon development with the alkaline aqueous solution.

The novolak resins (condensates of formaldehyde and phenol, cresol and other alkyl phenols) include homocondensates or cocondensates, such as phenol novolak resins, cresol novolak resins, phenol cresol novolak resins. These resins may be used alone or as mixtures of two or more. The molecular mass of the novolak resins and polyhydroxystyrene resins is at least 500, preferably 1000 to 500000, and more preferably 1000 to 100000 in terms of the number average molecular mass.

When it is less than 500, the film-forming ability is lower. When it is more than 1000, the film-forming ability at 10 to 100°C is good and besides the heat resistance is also good.

The aromatic azide compounds and aromatic sulfonylazide compounds (b) represented by the general formaula 1 do not precipitate from the resist solution, and do not remaining after development; simultaneously, high resolution and high sensitivity are obtained. The active nitrene produced from the light-excited azide compounds of the general formula 1 react with the polymer compounds (a) which results in an insolubilization of the exposed portions which are not dissolved even by development with an alkaline aqueous solution. The group represented by Y of the compounds of the general formula 1 forms a chromophore by conjugation with, for example, an aromatic azide group. When Y is a carbonyl group, amide group, amino group, ether group, or ester group, the conjugation effect is not so large, and the maximum absorption wavelength is in the relatively short wavelength region (less than 330 nm) and hence the resolution characteristics are improved because of the smaller diffraction of UV ray.

For example, p-azidophenyl-2-(N,N-dimethylamino)-ethyl ketone which has a carbonyl group as Y has a maximum description at 287 nm (molar absorption coefficient 16000), 2-(N,N-dimethylamino)-ethyl-p-azidobenzoate having an ester group as Y has a maximum absorption of 274 nm (molar absorption coefficient 16000), N,N-dimethyl-N'-p-azidobenzoylethylenediamine having an amide group as Y has a maximum absorption of 270 nm (molar absorption coefficient 17000), and 2-(N,N-dimethylamino)-ethyl-m-azidobenzoate having an ester group as Y and an azide group at m-position has a maximum absorption at 253 nm (molar absorption coefficient 18000).

The sensitivity of these photosensitive agents is considered to depend on the photoreactivity of the azide group and particularly reactivity of the active nitrene which is produced by photo-decomposition of the azide with the resin component. One of the controlling factors for the efficiency of the reaction between the active nitrene and the resin component is the distance between the reaction sites (the closer the reaction sites, the higher the efficiency), and this is considered to correlate with the compatibility of the molecules. The sensitizing efficiency of sensitizers is described in the publication of Nagamatsu and Inui "Photosensitive High Polymers", *1977*, page 172, published by Kodansha K.K. Therefore, a high sensitization has been aimed at by increasing the compatibility of resin component and aromatic azide compound. In addition to the polar group represented by Y, a hydroxyl group or amino group which is a polar group is introduced into the aromatic azide compound used in this invention at the terminal of its molecule for increasing the compatibility of the azide compound with polar novolak resins and polyhydroxystyrene resins. Thus, coating films prepared therefrom are uniform and have a practically acceptable high sensitivity.

Examples of aromatic azide compounds or aromatic sulfonylazide compounds used in the photosensitive resin compositions of this invention are azide group substituted benzoic acid esters having

a terminal amino group, such as 2-(N,N-dimethylamino)-ethyl-p-(or m-)azidobenzoate, 3-(N,N-dimethylamino)-propyl-p-(or m-)azidobenzoate, azide group substituted benzoic acid esters having a terminal hydroxyl group, such as 2-hydroxyethyl-p-(or m-)azidobenzoate, 2-(N,N-dimethylamino)-ethyl-p-azidocyanocinnamate, azide group substituted benzamides, such as N,N-dimethyl-N'-p-(or m)-azidobenzoylethylenediamine, N,N-dimethyl-N'-p-(or m-)azidobenzoylpropylenediamine, azide group substituted aromatic ketones, such as p-(or m-)azidophenyl-2-(N,N-dimethylamino)-ethyl ketone, sulfonyl azide group substituted benzoic acid ester sulfonyl azide compounds, such as 2-(N,N-dimethylamino)-ethyl-p-(or m-)sulfonylazidobenzoate.

The above enumerated aromatic azide compounds and aromatic sulfonylazide compounds may be prepared by, e.g., the following processes.

Azide or sulfonyl group substituted benzoic acid esters having a terminal amino group can be obtained by reacting the corresponding azido or sulfonylazidobenzoyl chloride with N,N-dialkylaminoalkyl alcohol to produce the hydrochloride of the objective compound and then treating the hydrochloride with an alkali such as sodium hydroxide.

Azide group substituted benzoic acid esters having a terminal hydroxyl group can be obtained by reacting the corresponding azidobenzoyl chloride with a large excess amount of an alkylene diol in the presence of an organic base such as pyridine, triethylamine.

Azide group substituted benzamides can be obtained by reacting the corresponding azidobenzoyl chloride with an N,N-dialkylalkylenediamine to produce the hydrochloride of the objective compound and then treating the hydrochloride with an alkali. p-(or m-)azidophenyl-2-(N,N-dimethylamino)-ethyl ketone can be prepared from azidoacetophenone by Mannich reaction using paraformaldehyde and dimethylamine hydrochloride.

The mixing ratio of the polymer compound (a) and the aromatic azide compound (b) in the photosensitive resin compositions of this invention is preferably within the range of from 0,5 to 150 parts by mass, and more preferably from 2 to 100 parts by mass of the aromatic azide compound per 100 parts by mass of the polymer compound. Below said range, in many cases, practically sufficient photosensitivity cannot be obtained, and above said range, in many cases, the film-forming ability is markedly decreased.

The photosensitive resin compositions of this invention are coated on to the surface of the substrate in the form of a solution in a suitable organic solvent. The solvent is required to dissolve all of the components of the photosensitive resin composition. For this purpose, there may be used ketones, such as acetone, methyl ethyl ketone, cyclohexanone, cellosolves, such as methyl cellosolve, ethyl cellosolve, ethyl cellosolve acetate, esters, such as ethyl acetate, butyl acetate, and the like. These solvents may be used alone or as mixtures of two or more. The amount of the solvent to be added is suitably 100 to 10000 and preferably 200 to 5000 parts by mass per 100 parts by mass of the resin composition comprising the polymer compound (a) and the azide compound (b).

If necessary, other subsidiary components may be contained in the photosensitive resin compositions of this invention in addition to the polymer compound (a) and the aromatic azide or sulfonylazide compound (b). Examples of these subsidiary components are thermal polymerization inhibitors for providing storage stability, halation inhibitors for preventing the substrate from halation, adhesion increasing agents for increasing adhesion to the substrate, dyes, pigments, fillers, flame retardants, sensitizers.

The method of forming patterns using the photosensitive resin compositions of this invention will be explained below.

The coating of the photosensitive resin composition on to a substrate may be carried out by spin-coating with a spinner, dipping, spraying, printing, which may be optionally chosen depending on the purpose. The resultant coating is dried at a suitable temperature (preferably lower than 120°C) to form a film. The thickness of the coating film can be adjusted by the coating method and the solid concentration and viscosity of the solution.

The coating film of the photosensitive resin composition on the substrate is locally exposed to ultraviolet rays through a photomask, and then unexposed portions are dissolved and removed with developing solutions to obtain relief patterns. As methods for exposure to form patterns there can be used both the contact printing and projection printing. Since the photosensitive resin composition of this invention has its sensitive region in the short wavelength region of less than 330 nm, it is preferred to use a photomask base material having high transmission for short wavelength light, such as quartz and the like, and an illumination source having high emission intensity in the short wavelength region, such as an Xe-Hg lamp.

The photosensitive resin composition of this invention can be developed with alkaline solutions as mentioned hereinbefore. Examples of these alkaline developing solutions are aqueous solutions of tetraalkylammonium hydroxides, such as tetramethylammonium hydroxide, and aqueous solutions of inorganic alkalis, such as trisodium phosphate, sodium hydroxide, but there is not limitation as long as they are alkaline solutions. The development can be effected by dipping development, spraying development, etc.

The invention will be further explained by the following examples where parts are based on mass.

Example 1

10 parts of a phenol novolak resin were dissolved in 90 parts of cyclohexanone, and then 1 part of 2-hydroxyethyl-p-azidobenzoate was dissolved therein to obtain a solution of a photosensitive resin composition. The 2-hydroxyethyl-p-azidobenzoate was dissolved instantaneously to become a homogeneous solution. Then, this solution was filtered under pressure using a filter having 1 μm pores.

The resulting solution was spin-coated onto a silicon wafer and then dried at 70°C for 20 minutes to obtain a coating film of 0,8 μm thickness. This coating film was covered and contacted with a quartz photomask having a stripe-pattern and then exposed for 5s to ultraviolet rays from a 500 W Xe-Hg lamp at a distance of 30 cm from the coating film. The coating film was then spray developed with a 0,15N aqueous potassium hydroxide solution and then rinsed with water to obtain a relief pattern having sharp edge profiles. There occurred neither precipitation of crystals nor were there any remaining azide fine particles in the pattern which occur when using crystallizable aromatic azide compounds, and the pattern as clean. A pattern with fine lines and spaces having a minimum width of 1 μm was obtained.

Example 2

10 parts of a cresol novolak resin and 2 parts of 2-(N,N-dimethylamino)-ethyl-p-azidobenzoate were dissolved in 120 parts of ethyl cellosolve acetate to obtain a solution of a photosensitive resin composition. This solution was then filtered under pressure with a filter having 0,2 μm pores.

The resulting solution was spin-coated onto a silicon wafer and dried at 70°C for 20 mins to obtain a coating film of 0,9 μm thickness. Under the same conditions as in example 1, said film was exposed to ultraviolet rays for 5s, then developed with 0,1N aqueous sodium hydroxide solution and rinsed with water to obtain a relief pattern having sharp edge profiles. A pattern with fine lines and spaces having a minimum width of 1 μm was obtained.

Example 3

10 parts of poly-p-vinylphenol and 3 parts of 2-(N,N-dimethylamino)-ethyl-m-azidobenzoate were dissolved in 120 parts of ethyl cellosove acetate to obtain a solution of a photosensitive resin composition. This solution was filtered under pressure with a filter having 0,2 μm pores.

The resulting solution was spin-coated onto an evenly abraded ceramic substrate and then dried at 70°C for 20 min to obtain a coating film of 1,0 μm thickness. Under the same conditions as in example 1, said film was exposed to ultraviolet rays for 5s, developed with a 0,2N aqueous solution of tetramethylammonium hydroxide and then rinsed with water to obtain a relief pattern having sharp edge profiles. A pattern with fine lines and spaces having a minimum width of 1,5 μm was obtained.

Example 4

10 parts of a phenol novolak resin and 3 parts of N,N-dimethyl-N′-p-azidobenzoylethylenediamine were dissolved in 60 parts of methyl cellosolve acetate to obtain a solution of a photosensitive resin composition, which was then filtered under pressure with a filter having 0,2 μm pores.

The resulting solution was spin-coated onto a silicon wafer to obtain a coating film of 0,8 μm thickness. Under the same conditions as in example 1 this film was exposed to ultraviolet rays for 5s, developed with a 0,2N aqueous solution of tetramethylammonium hydroxide and then rinsed with water to obtain a relief pattern having sharp edge profiles. A pattern with fine lines and spaces having a minimum width of 1,0 μm was obtained.

Example 5

10 parts of a phenol novolak resin and 5 parts of p-azidophenyl-2-(N,N-dimethylamino)-ethyl ketone were dissolved in a mixed solution comprising 60 parts of cyclohexanone and 40 parts of ethyl cellosolve to obtain a solution of a photosensitive resin composition, which was filtered under pressure with a filter having 0,2 μm pores.

The resulting solution was spin-coated onto a silicon wafer and then dried at 70°C for 20 min to obtain a coating film of 0,9 μm thickness. Under the same conditions as in example 1, this film was exposed to ultraviolet rays for 10s, developed with a 0,1N aqueous solution of tetramethylammonium hydroxide and then rinsed with water to obtain a relief pattern having sharp edge profiles. A pattern with fine lines and spaces having a minimum width of 1 μm was obtained.

Example 6

10 parts of poly-p-vinylphenol and 2 parts of 3-(N,N-dimethylamino)-propyl-p-azidobenzoate were dissolved in 100 parts of ethyl cellosolve acetate to obtain a solution of a photosensitive resin composition, which was then filtered under pressure with a filter having 0,2 μm pores.

The resulting solution was spin-coated onto a silicon wafer and dried at 70°C for 20 min to obtain a coating film of 0,9 μm thickness. Under the same conditions as in example 1, this coating film was exposed to ultraviolet rays for 5s, developed with a 0,2N aqueous solution of tetramethylammonium hydroxide and rinsed with water to obtain a relief pattern having sharp edge profiles. A pattern with fine repeating lines and spaces having a minimum width of 1 μm was obtained.

Example 7

The composition of Example 1 was spin-coated onto a sandblasted clean aluminium foil and dried.

A printing plate obtained under the same exposure and development conditions as in example 1 was mounted on a printing cylinder of a lithographic printing machine, and printing was carried out with a printing ink and an etching solution, whereby good prints were obtained. Accordingly, the composition of this invention can be used for making printing plates.

Example 8

10 parts of poly-p-vinylphenol were dissolved in 120 parts of ethyl cellosolve acetate; in the resulting solution were dissolved 3 parts of 3-(N,N-dimethylamino)-propyl-m-azidobenzoate to obtain a solution of a photosensitive composition. As in example 1, the dissolution of the aromatic azide component occurred instantaneously. This solution was then filtered under pressure with a filter having 1 µm pores.

The resulting solution was spin-coated onto a silicon wafer and then dried at 70°C for 20 min to obtain a coating film of 0,9 µm thickness. This film was covered and contacted with a stripe-pattern quartz photomask and exposed for 5s to ultraviolet rays from a 500 W Xe-Hg lamp at a distance of 30 cm from the film. The film was then spray-developed with a 0,2N aqueous solution of tetramethylammonium hydroxide and then rinsed with water to obtain a relief pattern having sharp edge profiles. The resolution of the pattern was sufficiently high as in example 1.

Example 9

10 parts of a phenol novolak resin were dissolved in 40 parts of methyl cellosolve acetate; in the resulting solution were dissolved 3 parts of N,N-dimethyl-N'-p-azidobenzoylethylenediamine to obtain a solution of a photosensitive resin composition. As in example 1, the dissolution of the aromatic azide component occured instantaneously. This solution was then filtered under pressure by a filter having 1 µm pores.

The resulting solution was spin-coated onto a silicon wafer and then dried at 70°C for 20 min to obtain a coating film of 0,9 µm thickness. This film was covered and contacted with a stripe-pattern quartz photomask and exposed for 5s to ultraviolet rays from a 500 W Xe-Hg lamp at a distance of 30 cm from the film. The film was then spray-developed with a 0,2N aqueous solution of tetramethylammonium hydroxide and then rinsed with water to obtain a relief pattern having sharp edge profiles. The resolution of the pattern was sufficiently high as in Example 1.

Example 10

10 parts of a phenol novolak resin were dissolved in 100 parts of methyl cellosolve acetate; in this solution were dissolved 3 parts of 2-(N,N-dimethylamino)-ethyl-p-azidocinnamate to obtain a solution of a photosensitive resin composition. The dissolution of the aromatic azide component occurred instantaneously, and a homogeneous solution was obtained. This solution was then filtered under pressure by a filter having 1 µm pores.

The resulting solution was spin-coated onto a silicon wafer and then dried at 70°C for 20 min to obtain a coating film of 1,0 µm thickness. This coating film was covered and contacted with a stripe-pattern soda glass photomask and exposed for 10s to ultraviolet rays from a 500 W high pressure mercury lamp at a distance of 30 cm from the film. The film was then spray-developed with a 0,2N aqueous solution of tetramethylammonium hydroxide and then rinsed with water to obtain a relief pattern having sharp edge profiles. The resolution of the pattern was sufficiently high as in example 1.

Example 11

10 parts of a phenol novolak resin were dissolved in 100 parts of methyl cellosolve acetate; in this solution were dissolved 4 parts of N,N-diethylamino-N'-p-azidobenzylideneacetylethylenediamine to obtain a solution of a photosensitive resin composition. The dissolution of aromatic azide component occurred instantaneously, and a homogeneous solution was obtained. This solution was then filtered under pressure by a filter having 1 µm pores.

The resulting solution was spin-coated onto a silicon wafer and then dried at 70°C for 20 min to obtain a coating film of 1,1 µm thickness. This coating film was covered and contacted with a stripe-pattern soda glass photomask and exosed for 10s to ultraviolet rays from a 500 W high pressure mercury lamp at a distance of 30 cm from the film. The film was then developed with a 0,2N aqueous solution of tetramethylammonium hydroxide by the dipping method and then rinsed with water to obtain a relief pattern having sharp edge profiles. The resolution of the pattern was sufficiently high as in example 1.

Example 12

10 parts of a poly-p-vinylphenol resin were dissolved in 100 parts of methyl cellosolve acetate; in this solsution were dissolved 3 parts of 2-(N,N-dimethylamino)-ethyl-p-azidoα-cyanocinnamate to obtain a solution of a photosensitive resin composition. The dissolution of the aromatic azide component occurred instantaneously and a homogeneous solution was obtained. This solution was then filtered under pressure by a filter having 1 µm pores.

The resulting solution was spin-coated onto a silicon wafer and dried at 70°C for 20 min to obtain a

coating film of 0,9 µm thickness. This coating film was covered and contacted with a stripe-pattern soda glass photomask and exposed to ultraviolet rays for 15s from a 500 W high pressure mercury lamp at a distance of 30 cm from the film. This film was developed with a 0,2N aqueous solution of tetramethylammonium hydroxide by the dipping method and then rinsed with water to obtain a relief pattern having sharp edge profiles. The resolution of the pattern was sufficiently high as in Example 1.

Example 13

10 parts of a poly-p-vinylphenol resin were dissolved in 100 parts of ethyl cellosolve acetate; in this solution was dissolved 0,5 part of 2-hydroxyethyl-p-azidobenzoate to obtain a solution of a photosensitive resin composition. The dissolution of the aromatic azide component occurred instantaneously, and a homogeneous solution was obtained. This solution was then filtered under pressure by a filter having 1 µm pores.

The resulting solution was spin-coated onto a silicon wafer and dried at 70°C for 20 min to obtain a coating film of 0,7 µm thickness. This coating film was covered and contacted with a stripe-pattern quartz photomask and exposed for 15s to ultraviolet rays from a 500W high pressure mercury lamp at a distance of 30 cm from the film. The film was then spray-developed with a 0,2N aqueous solution of tetramethylammonium hyroxide and then washed with water to obtain a relief pattern having sharp edge profiles. The resolution of the pattern was sufficiently high as in example 1.

Comparative Example

The resolution of a commercial negative-type photoresist on the basis of a cyclized polyisoprene rubber and an aromatic bisazide compound as photosensitive agent was evaluated for comparison with that of compositions according to the invention.

The above-mentioned photoresist solution was spin-coated onto a silicon wafer and then dried at 90°C for 30 min to obtain a coating film of 0,8 µm thickness. This coating film was covered and contacted with the same photomask as used in examples 1 to 6 and was exposed for 3s to ultraviolet rays from a 500 W high pressure mercury lamp at a distance of 30 cm from the film. The film was then developed with a mixed liquid composed of 3 parts by volume of xylene and 7 parts by volume of n-heptane and then was rinsed with n-butyl acetate to obtain a relief pattern. In this experiment, the resolution in terms of the width of the obtained fine line pattern was merely 2 µm in minimum.

In the case of line patterns of less than 2 µm in width, patterns reproduced from the straight line pattern of the photomask revealed winding line patterns. Thus the patterns of the photomask were not accurately transferred.

**Claims**

1. Photosensitive resin compositions comprising (a) at least one polymer compound selected from novolak resin and polyhydroxystyrene resins and (b) an azide compound, characterized in that the azide compound is represented by the general formula 1

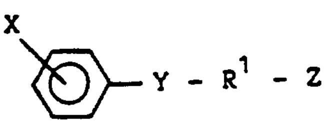

(1),

wherein

X is $—N_3$ or $—SO_2N_3$,

Y is —COO—, —CONH—, —NH—, —O—, —OCO—, —NHCO—, —CO—, —CH=CHCOO—, —CH=CHCONH—, —CH=CCOO—, —CH=CCONH—, —CH=CHCO— or —COCH=CH—,
(with CN attached to the C of —CH=CCOO— and —CH=CCONH—)

$R^1$ is a lower alkylene, a hydroxyalkylene or an aminoalkylene and

Z is $—R^2$, $—OR^3$, 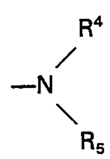 ,

$—OCOR^6$, $—COOR^7$, $—NHCOR^8$ or $—CONR^4R^5$, wherein $R^2$ and $R^6$ to $R^8$ are lower alkyl, $R^4$ and $R^5$ are lower alkyl or hydrogen, $R^3$ is hydrogen, lower alkyl or $-(CH_2CH_2O)_n-R^9$ wherein n is an integer of 3 or less and $R^9$ is hydrogen or a lower alkyl.

2. Photosensitive resin compositions according to claim 1, characterized by an azide compound of formula 1, wherein Y is —COO—, —CONH—, —NH—, —O—, —OCO—, —NHCO— or —CO—.

3. Liquid photosensitive resin compositions according to claim 1, characterized by an azide compound of formula 1 wherein

X is $—N_3$,

Y is —COO— or —NHCO—,

$R^1$ is $—CH_2CH_2—$, $—CH_2CH_2CH_2—$, $—CH_2CH_2OCH_2CH_2CH_2—$ or

$CH_3$
|
$—CH_2CH_2NCH_2CH_2—$ and

Z is —OH, $—NH_2$, $—N(CH_3)_2$, $—N(C_2H_5)_2$ or $—N(C_3H_7)_2$.

4. Photosensitive resin compositions according to any of claims 1 to 3, characterized in that they comprise a solvent.

5. Photosensitive resin compositions according to one of claims 1 to 4, characterized in that the azide compound of the general formula 1 is at least one compound selected from 2-(N,N-dimethylamino)-ethyl-p-azidobenzoate, 2-(N,N-dimethylamino)-ethyl-m-azidobenzoate, 3-(N,N-dimethylamino)-propyl-p-azidobenzoate, 3-(N,N-dimethylamino)-propyl-m-azidobenzoate, 2-hydroxyethyl-p-azidobenzoate, 2-hydroxyethyl-m-azidobenzoate, N,N-dimethyl-N'-p-azidobenzoylethylenediamine, N,N-dimethyl-N'-m-azidobenzoylethylenediamine, N,N-dimethyl-N'-p-azidobenzoylpropylenediamine, N,N-dimethyl-N'-m-azidobenzoylpropylenediamine, p-azidophenyl-2-(N,N-dimethylamino)-ethyl ketone, m-azidophenyl-α-(N,N-dimethylamino)-ethyl ketone, 2-(N,N-dimethylamino)-ethyl-p-sulfonylazidobenzoate and 2-(N,N-dimethylamino)-ethyl-m-sulfonylazidobenzoate.

6. Photosensitive resin compositions according to claim 2, characterized in that the azide compound of the general formula 1 is at least one compound selected from 2-(N,N-dimethylamino)-ethyl-p-azidobenzoate, 2-(N,N-dimethylamino)-ethyl-m-azidobenzoate, 3-(N,N-dimethylamino)-propyl-m-azidobenzoate, 2-hydroxyethyl-p-azidobenzoate, 2-hydroxyethyl-m-azidobenzoate, N,N-dimethyl-N'-p-azidobenzoylethylenediamine, N,N-dimethyl-N'-m-azidobenzoylethylenediamine, N,N-dimethyl-N'-p-azidobenzoylpropylenediamine, N,N-dimethyl-N'-m-azidobenzoylpropylenediamine, p-azidophenyl-2-(N,N-dimethylamino)-ethyl-p-sulfonylazidobenzoate and 2-(N,N-dimethylamino)-ethyl-m-sulfonyl-azidobenzoate.

7. Photosensitive resin compositions according to claim 3, characterized in that the azide compound of the general formula 1 is at least one compound selected from 2-(N,N-dimethylamino)-ethyl-p-azidobenzoate, 2-(N,N-dimethylamino)-ethyl-m-benzoate, 3-(N,N-dimethylamino)-propyl-p-azidobenzoate, 3-(N,N-dimethylamino)-propyl-m-azidobenzoate, 2-hydroxyethyl-p-azidobenzoate, 2-hydroxyethyl-m-azidobenzoate, N,N-dimethyl-N'-p-azidobenzoylethylenediamine, N,N-dimethyl-N'-m-azidobenzoyl ethylenediamine, N,N-dimethyl-N'-p-azidobenzoylpropylenediamine, N,N-dimethyl-N'-m-azidobenzoyl-propylenediamine, p-azidophenyl-2-(N,N-dimethylamino)-ethyl ketone and m-azidophenyl-2-(N,N-dimethylamino)-ethyl ketone.

8. Photoresistive resin compositions according to claim 4, characterized in that they comprise a solvent which is at least one compound selected from acetone, methyl ethyl ketone, cyclohexanone, methyl cellosolve, ethyl cellosolve, ethyl cellosolve acetate, ethyl acetate and butyl acetate.

9. Photosensitive resin compositions according to any of claims 1 to 8, characterized in that the azide compound of formula 1 is present in an amount of 0,5 to 150 parts by mass per 100 parts by mass of the polymer compound.

10. Photosensitive resin compositions according to any of claims 1 to 9, characterized in that the solvent is present in an amount of 100 to 10000 parts by mass per 100 parts by mass of the polymer compound.

**Patentansprüche**

1. Lichtempfindliche Harzzusammensetzungen mit (a) mindestens einem Polymer, ausgewählt unter Novolakharz und Polyhydrostyrolharzen und (b) einem Azid, dadurch gekennzeichnet, daß das Azid eine Verbindung der allgemeinen Formel 1 ist

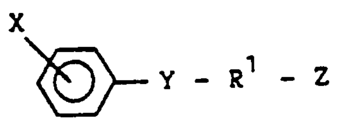

(1),

in der

X $—N_3$ oder $—SO_2N_3$ ist,

Y —COO—, —CONH—, —NH—, —O—, —OCO—, —NHCO—, —CO—, —CH=CHCOO—,

—CH=CHCONH—, —CH=CCOO—, —CH=CCONH—, —CH=CHCO— oder —COCH=CH— ist,
(wobei in —CH=CCOO— und —CH=CCONH— jeweils CN am C gebunden ist, wie gedruckt:)

$R^1$ niederes Alkylen, Hydroxyalkylen oder Aminoalkylen ist und

$$Z\ —R^2,\ —OR^3,\ —N\begin{matrix}R^4\\ \diagup\\ \\ \diagdown\\ R^5\end{matrix},$$

$—OCOR^6$, $—COOR^7$, $—NHCOR^8$ oder $—CONR^4R^5$, wobei $R^2$ und $R^6$ bis $R^8$ niedriges Alkyl, $R^4$ und $R^5$ niedriges Alkyl oder Wasserstoff, $R^3$ Wasserstoff, niedriges Alkyl oder $-(CH_2CH_2O)_nR^9$ ist, wobei n 3 oder weniger und $R^9$ Wasserstoff oder niedriges Alkyl ist.

2. Lichtempfindliche Harzzusammensetzungen nach Anspruch 1, gekennzeichnet durch ein Azid der Formel 1, in der Y —COO—, —CONH—, —NH—, —O—, —OCO—, —NHCO— oder —CO— ist.

3. Flüssige lichtempfindliche Harzzusammensetzungen nach Anspuch 1, gekennzeichnet durch ein Azid der Formel I, in der

X $—N_3$,

Y —COO— oder —NHCO—,

$R^1$ $—CH_2CH_2—$, $—CH_2CH_2CH_2—$, $—CH_2CH_2OCH_2CH_2CH_2$ oder

$$—CH_2CH_2\overset{\displaystyle CH_3 \atop |}{N}CH_2CH_2—$$ und

Z —OH, $—NH_2$, $—N(CH_3)_2$, $—N(C_2H_5)_2$ oder $—N(C_3H_7)_2$ ist.

4. Lichtempfindliche Harzzusammensetzungen nach einem der Ansprüche 1 bis 3, dadurch gekennzeichnet, daß sie ein Lösungsmittel enthalten.

5. Lichtempfindliche Harzzusammensetzusngen nach einem der Ansprüche 1 bis 4, dadurch gekennzeichnet, daß das Azid der allgemeinen Formel 1 mindestens eine Verbindung, ausgewählt unter 2-(N,N-Dimethylamino)-ethyl-p-azidobenzoat, 2-(N,N-Dimethylamino)-ethyl-m-azidobenzoat, 3-(N,N-Dimethylamino)-propyl-p-azidobenzoat, 3-(N,N-Dimethylamino)-propyl-m-azidobenzoat, 2-Hydroxyethyl-p-azidobenzoat, 2-Hydroxyethyl-m-azidobenzoat, N,N-Dimethyl-N'-p-azidobenzoylethylendiamin, N,N-Dimethyl-N'-m-azidobenzoylethylendiamin, N,N-Dimethyl-N'-p-azidobenzoylpropylendiamin, N,N-Dimethyl-N'-m-azidobenzoylpropylenediamin, p-Azidophenyl-2-(N,N-dimethylamino)-ethylketon, m-Azidophenyl-α-(N,N-dimethylamino)-ethylketon, 2-(N,N-Dimethylamino)-ethyl-p-sulfonylazidobenzoat und 2-(N,N-Dimethylamino)-ethyl-m-sulfonylazidobenzoat ist.

6. Lichtempfindliche Harzzusammensetzungen nach Anspruch 2, dadurch gekennzeichnet, daß das Azid der Formel 1 mindestens eine Verbindung, ausgewählt unter 2-(N,N-Dimethylamino)-ethyl-p-azidobenzoat, 2-(N,N-Dimethylamino)-ethyl-m-azidobenzoat, 3-(N,N-Dimethylamino)-propyl-m-azidobenzoat, 2-Hydroxyethyl-m-azidobenzoat, N,N-Dimethyl-N'-p-azidobenzoylethylendiamin, N,N-Dimethyl-N'-m-azidobenzoylethylendiamin, N,N-Dimethyl-N'-p-azidobenzoylpropylendiamin, N,N-Dimethyl-N'-m-azidobenzoylpropylendiamin, p-Azidophenyl-2-(N,N-dimethylamino)-ethyl-p-sulfonylazidobenzoat und 2-(N,N-Dimethylamino)-ethyl-m-sulfonylazidobenzoat ist.

7. Lichtempfindliche Harzzusammensetzungen nach Anspruch 3, dadurch gekennzeichnet, daß das Azid der Formel 1 mindestens eine Verbindung, ausgewählt unter 2-(N,N-Dimethylamino)-ethyl-p-azidobenzoat, 2-(N,N-Dimethylamino)-ethyl-m-azidobenzoat, 3-(N,N-Dimethylamino)-propyl-p-azidobenzoat, 3-(N,N-Dimethylamino)-propyl-m-azidobenzoat, 2-Hydroxy-p-azidobenzoat, 2-Hydroxyethyl-m-azidobenzoat, N,N-Dimethyl-n'-p-azidobenzoylethylendiamin, N,N-Dimethyl-N'-m-azidobenzoylethylendiamin, N,N-Dimethyl-N'-p-azidobenzoylpropylendiamin, N,N-Dimethyl-N'-m-azidobenzoylpropylendiamin, p-Azidophenyl-2-(N,N-dimethylamino)-ethylketon und m-Azidophenyl-2-(N,N-dimethylamino)-ethylketon ist.

8. Lichtempfindliche Harzzusammensetzungen nach Anspruch 4, dadurch gekennzeichnet, daß sie ein Lösungsmittel enthalten, das mindestens eine Verbindung wie Aceton, Methylethylketon, Cyclohexanon, Methylcellosolve, Ethylcellosolve, Ethylcellosolveacetat, Ethylacetat und Butylacetat ist.

9. Lichtempfindliche Harzzusammensetzungen nach einem der Ansprüche 1 bis 8, dadurch gekennzeichnet, daß das Azid der Formel 1 in einer Menge von 0,5 bis 150 Masseteile je 100 Masseteile Polymer vorhanden ist.

10. Lichtempfindliche Harzzusammensetzungen nach einem der Ansprüche 1 bis 9, dadurch gekennzeichnet, daß das Lösungsmittel in einer Menge von 100 bis 10000 Masseteile je 100 Masseteile Polymer vorhanden ist.

**Revendications**

1. Composition de résine photosensible comprenant (a) au moins un composé polymère choisi parmi la résine novolaque et les résines de polyhydroxystyrène et, (b) un composé azide, caractérisée en ce que le composé azide est représenté par la formule générale (1) suivante:

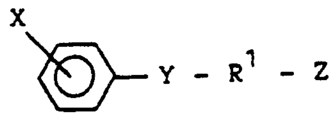

(1),

dans laquelle

X est $-N_3$ ou $-SO_2N_3$,

Y et $-COO-$, $-CONH-$, $-NH-$, $-O-$, $-OCO-$, $-NHCO-$, $-CO-$, $-CH=CHCOO-$, $-CH=CHCONH-$, $-CH=C(CN)COO-$, $-CH=C(CN)CONH-$, $-CH=CHCO-$ ou $-COCH=CH-$ ist,

$R^1$ est un alkylène inférieur, un hydroxyalkylène ou un aminoalkylène et

Z est $-R^2$, $-OR^3$, $-N(R^4)(R^5)$, $-OCOR^6$, $-COOR^7$, $-NHCOR^8$ ou $-CONR^4R^5$, où $R^2$ et $R^6$ à $R^8$ représentent un alkyle inférieur, $R^4$ et $R^5$ représentent un alkyle inférieur ou de l'hydrogène, $R^3$ est de l'hydrogène, un alkyle inférieur ou $-(CH_2CH_2O)_nR^9$, n étant un entier égal ou inférieur à 3 et $R^9$ étant de l'hydrogène ou un alkyle inférieur.

2. Composition de résine photosensible selon la revendication 1, caractérisée par un composé azide répondant à la formule (1), dans laquelle Y est $-COO-$, $-CONH-$, $-NH-$, $-O-$, $-OCO-$, $-NHCO-$ ou $-CO-$.

3. Composition de résine photosensible liquide selon la revendication 1, caractérisée par un composé azide répondant à la formule (1), dans laquelle:

X est $-N_3$,

Y est $-COO-$ ou $-NHCO-$

$R^1$ est $-CH_2CH_2-$, $-CH_2CH_2CH_2-$, $-CH_2CH_2OCH_2CH_2CH_2$ ou $-CH_2CH_2N(CH_3)CH_2CH_2-$, et

Z est $-OH$, $-NH_2$, $-N(CH_3)_2$, $-N(C_2H_5)_2$ ou $-N(C_3H_7)_2$.

4. Composition de résine photosensible selon l'une quelconque des revendications 1 à 3, caractérisées en ce qu'elles comprend un solvant.

5. Composition de résine photosensible selon l'une des revendications 1 à 4, caractérisée en ce que le composé azide répondant à la formule générale (1) est au moins un composé choisi parmi: le 2-(N,N-diméthylamino)-éthyl-p-azidobenzoate, le 2-(N,N-diméthylamino)-éthyl-m-azidobenzoate, le 3-(N,N-diméthylamino)-propyl-p-azidobenzoate, le 3-(N,N-diméthylamino)-propyl-m-azidobenzoate, le 2-hydroxyéthyl-p-azidobenzoate, le 2-hydroxyéthyl-m-azidobenzoate, la N,N-diméthyl-N'-p-azidobenzoyléthylènediamine, la N,N-diméthyl-N'-m-azidobenzoyléthylènediamine, la N,N-diméthyl-N'-p-azidobenzoylpropylènediamine, la N,N-diméthyl-N'-m-azidobenzoylpropylènediamine, la p-azidophényl-2-(N,N-diméthylamino)-éthylcétone, la m-azidophényl-α-(N,N-diméthylamino)-éthylcétone, la 2-(N,N-diméthylamino)-éthyl-p-sulfonylazidobenzoate et le 2-(N,N-diméthylamino)-éthyl-m-sulfonylazidobenzoate.

6. Composition de résine photosensible selon la revendication 2, caractérisée en ce que le composé azide répondant à la formule générale (1) est au moins un composé choisi parmi: le 2-(N,N-diméthylamino)-éthyl-p-azidobenzoate, le 2-(N,N-diméthylamino)-éthyl-m-azidobenzoate, le 3-(N,N-diméthylamino)-propyl-m-azidobenzoate, le 2-hydroxyéthyl-p-azidobenzoate, le 2-hydroxyéthyl-m-azidobenzoate, la N,N-diméthyl-N'-p-azidobenzoyléthylènediamine, la N,N-diméthyl-N'-p-azidobenzoyléthylènediamine, la N,N'-diméthyl-N'-p-azidobenzoylpropylènediamine, la N,N-diméthyl-N'-m-azidobenzoylpropylènediamine, le p-azidophényl-2-(N,N-diméthylamino)-éthyl-p-sulfonylazidobenzoate et le 2-(N,N-diméthylamino)-éthyl-m-sulfonylazidobenzoate.

7. Composition de résine photosensible selon la revendication 3, caractérisée en ce que le composé azide répondant à la formule générale (1) est au moins un composé choisi parmi: le 2-(N,N-diméthylamino)-éthyl-p-azidobenzoate, le 2-(N,N-diméthylamino)-éthyl-m-azidobenzoate, le 3-(N,N-diméthylamino)-propyl-p-azidobenzoate, le 3-(N,N-diméthylamino)-propyl-m-azidobenzoate, le 2-hydroxyéthyl-p-azidobenzoate, le 2-hydroxyéthyl-m-azidobenzoate, la N,N-diméthyl-N'-p-azidobenzoyléthylènediamine, la N,N-diméthyl-N'-m-azidobenzoyléthylènediamine, la N,N-diméthyl-N'-p-azidobenzoylpropylènediamine, la N,N-diméthyl-N'-m-azidobenzoylpropylènediamine, la p-azidophényl-2-(N,N-diméthylamino)-éthylcétone et la m-azidophényl-2-(N,N-diméthylamino)-éthylcétone.

8. Composition de résine photosensible selon la revendication 4, caractérisée en ce qu'elle comprend un solvant qui est au moins un composé choisi parmi l'acétone, la méthyléthylcétone, la cyclohexanone le méthylcellosolve, l'éthylcellosolve, l'acétate d'éthylcellosolve, l'acétate d'éthyle et l'acétate de butyle.

9. Composition de résine photosensible selon l'une quelconque des revendications 1 à 8, caractérisée en ce que le composé azide répondant à la formule (1) est présent en une quantité comprise entre 0,5 et 150 parties en masse pour 100 parties en masse pour 100 parties en masse du composé polymère.

10. Composition de résine photosensible selon l'une quelconque des revendications 1 à 9, caractérisée en ce que le solvant est présent en une quantité comprise entre 100 et 10000 parties en masse pour 100 parties en masse du composé polymère.